(19) **Europäisches Patentamt**

**European Patent Office**

**Office européen des brevets**

(11) **EP 0 994 565 B1**

(12) **EUROPEAN PATENT SPECIFICATION**

(45) Date of publication and mention
of the grant of the patent:
**03.05.2006 Bulletin 2006/18**

(51) Int Cl.:
*H03K 17/082* (2006.01)

(21) Application number: **99118891.3**

(22) Date of filing: **24.09.1999**

(54) **Temperature sensing in voltage drive type semiconductor device**

Temperaturerfassung in einem spannungsgesteuerten Halbleiter-Bauelement

Détermination de la température dans un dispositif semi-conducteur du type à commande par la tension

(84) Designated Contracting States:
**CH DE LI**

(30) Priority: **12.10.1998 JP 28906098**

(43) Date of publication of application:
**19.04.2000 Bulletin 2000/16**

(73) Proprietors:
• **Hitachi, Ltd.**
 **Chiyoda-ku,**
 **Tokyo 100-8010 (JP)**
• **HITACHI HARAMACHI ELECTRONICS CO., LTD.**
 **Hitachi-shi,**
 **Ibaraki 317-0072 (JP)**

(72) Inventors:
• **Hasegawa, Hiroyuki**
 **Hitachi-shi,**
 **Ibaraki 317-0076 (JP)**
• **Kurosu, Toshiki**
 **Hitachi-shi,**
 **Ibaraki 316-0001 (JP)**

• **Sugayama, Shigeru**
 **Hitachi-shi,**
 **Ibaraki 319-1221 (JP)**

(74) Representative: **Strehl Schübel-Hopf & Partner**
 **Maximilianstrasse 54**
 **80538 München (DE)**

(56) References cited:
**EP-A- 0 702 455**

• **PATENT ABSTRACTS OF JAPAN vol. 1996, no. 06, 28 June 1996 (1996-06-28) & JP 08 032361 A (TOYOTA AUTOM LOOM WORKS LTD), 2 February 1996 (1996-02-02)**
• **ECKEL H-G ET AL.: "Optimization of the turn-off performance of IGBT at overcurrent and short circuit current" POWER ELECTRONICS AND APPLICATIONS, vol. 2, 13 - 16 September 1993, pages 317-322, XP002237513 Brighton**

**Description**

The present invention relates to temperature sensing circuit and a temperature sensing method for a voltage drive type semiconductor device.

In temperature sensing for protective functions in a conventional IGBT (Insulated Gate Bipolar Transistor) module containing IGBTs of voltage drive type semiconductor devices, a temperature sensing circuit for detecting temperature rise of the IGBT module in order to switch off the IGBT is necessary. For example, such conventional IGBT module is disclosed in Japanese Patent Application Laid-open No. 7-67389.

Temperature rise of an IGBT module is detected by a temperature sensing circuit using a thermistor and the signal is transmitted to a control circuit, the thermistor is attached on a cooling fin mounting the IGBT module thereon. When temperature of the cooling fin rises, resistance of the thermistor is decreased and the terminal voltage is also decreased. When the temperature exceeds a preset temperature, the temperature sensing circuit operates to switch off the IGBT by making use of this characteristic.

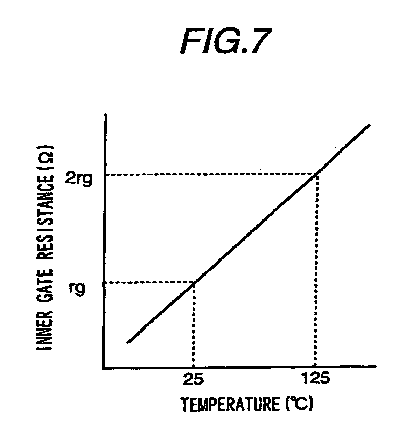

Figure 6 shows a temperature sensing circuit 31 using a thermistor 29 attached in a cooling fin, a control circuit 26 of an IGBT module 9a, and wiring of a gate drive circuit 12.

In the temperature sensing circuit 31, one end of the thermistor is connected to a resistor 30 in series and also connected to an input terminal of a voltage comparing circuit 13, and the other end is connected to the grounding potential. The other input terminal of the voltage comparing circuit 13 is connected to a constant voltage circuit 18, and the output terminal is connected to the control circuit 26.

In Figure 6, since the thermistor for temperature sensing is a part on the cooling fin, temperature change of the IGBT is sensed by temperature of the cooling fin. Therefore, when an IGBT element 1a generates heat by overcurrent or the like, there arises a problem that temperature transmitted to the thermistor differs depending on the position of the heating element or accuracy of sensing temperature is decreased as the distance between the heating element and the thermistor increases

A temperature sensing circuit in the line with the preamble of present claim 1 is disclosed in EP-A-0 702 455. Further relevant prior art is disclosed in "Optimization of the furn-off performance of IGBT at overcurrent and short-circuit current" be Eckel et al. in POWER ELECTRONICS AND APPLICATIONS, Vol. 2, Sept. 1993, pages 317-322.

SUMMARY OF THE INVENTION

An object of the present invention is to provide a high reliable temperature sensing circuit and a high reliable temperature sensing method by taking the above-mentioned problem into consideration.

The object is met by the temperature sensing circuit defined in claim 1.

A temperature sensing circuit and a temperature sensing method in accordance with the present invention to be described below are applied to a voltage drive type semiconductor device comprising a semiconductor element controlling current flowing between a pair of main electrodes by a voltage applied to an insulated gate electrode; a gate terminal electrically connected to the insulated gate electrode; the other terminal electrically connected to the other main electrode among the pair of main electrode. As the semiconductor element, there are various kinds of semiconductor elements having an insulated gate electrode such as an MOSFET and so on in addition to an IGBT. As the voltage drive type semiconductor device, there are, for example, a power semiconductor module, a resin seal type semiconductor device and so on.

In the temperature sensing circuit in accordance with the present invention, a resistor having a positive temperature coefficient is connected between the gate terminal and the insulated gate electrode of the voltage drive type semiconductor device. Further, the temperature sensing circuit comprises a means for receiving a voltage including a voltage drop by the resistor in a circuit portion between the gate terminal and the other terminal and sensing the temperature of the voltage drive type semiconductor device based on the voltage.

The temperature sensing circuit in accordance with the present invention described above makes use of the fact that when a resistor having a positive temperature coefficient is connected between the gate terminal and the insulated gate electrode, a voltage including a voltage drop by the resistor in a circuit portion between the gate terminal and the other terminal is changed by the temperature of the voltage drive type semiconductor device. Therefore, the sensing response to a temperature change in the voltage drive type semiconductor device becomes fast. Accordingly, by sensing the temperature based on the voltage, a temperature sensing circuit having a high reliability can be obtained.

In the temperature sensing method in accordance with the present invention, a resistor having a positive temperature coefficient is connected between the gate terminal and the insulated gate electrode; and temperature is sensed based on a voltage including a voltage drop by the resistor in a circuit portion between the gate terminal and the other terminal during a Miller effect being generated when the semiconductor element turns off.

The temperature sensing method in accordance with the present invention described above makes use of the fact that when a resistor having a positive temperature coefficient is connected between the gate terminal and the insulated gate electrode, a voltage including a voltage drop by the resistor in a circuit portion between the gate terminal and the other terminal during a Miller effect is generated when the semiconductor element turns off. Accordingly, the sensing response becomes fast and a temperature sensing circuit having a high reliability can be obtained. Preferable modifications are defined in the subclaims.

It is preferable that the resistor connected between the gate terminal and the insulated gate electrode in the voltage drive type semiconductor device is contained in the voltage drive type semiconductor device. By doing so, since the resistor is placed in a position near the semiconductor element of heat generating source, the temperature sensing accuracy can be improved. Further, as the resistor, it is possible to use a resistor contained in the voltage drive type semiconductor device for a purpose other than temperature sensing such as a gate resistor.

A drive device for a voltage drive type semiconductor device in accordance with the present invention comprises a drive circuit connected to the gate terminal through another resistor and connected to the other terminal; and the temperature sensing circuit in accordance with the present invention described above.

The drive device for temperature sensing circuit in accordance with the present invention described above makes use of the fact that when a resistor having a positive temperature coefficient is connected between the gate terminal and the insulated gate electrode and another resistor is connected between the drive circuit and the gate terminal, a voltage including a voltage drop by the resistor in a circuit portion between the gate terminal and the other terminal is changed by the temperature of the voltage drive type semiconductor device. Therefore, by controlling the drive device based on the output signal of the temperature sensing circuit, highly accurate protective operation to temperature can be performed.

In a case where the voltage drive type semiconductor device comprises a plurality of semiconductor elements, the voltage drive type semiconductor device having the following structure is suitable for applying the temperature sensing circuit and the temperature sensing method described above thereto. That is, a voltage drive type semiconductor device comprising a semiconductor element controlling current flowing between a pair of main electrodes by a voltage applied to an insulated gate electrode; a gate terminal electrically connected to the insulated gate electrode; the other terminal electrically connected to the other main electrode among the pair of main electrode; and a resistor having a positive temperature coefficient connected between the gate terminal and the insulated gate electrode; another semiconductor element having an insulated gate electrode and connected to the semiconductor element in parallel, and the resistor comprises a first resistor and a second resistor connected to each other in series, and a third resistor is connected between a junction point of the first resistor and the second resistor and the insulated gate electrode of the other semiconductor element.

## BRIEF DESCRIPTION OF THE DRAWINGS

Figures 1A and 1B shows a circuit diagram of a first embodiment in the present invention.
Figure 2 shows a circuit diagram of a second embodiment in the present invention.
Figure 3 shows a circuit diagram of a third embodiment in the present invention.
Figure 4 is a circuit diagram of a fourth embodiment in the present invention.
Figures 5A and 5B are views for explaining the operation of an each embodiment of the present invention.
Figure 6 is a circuit diagram of an example in the prior art of the present invention.
Figure 7 shows a relationship between temperature and inner gate resistance in the first embodiment.

## DETAILED DESCRIPTION OF THE PREFERRED EMBODIMENT

(First embodiment)

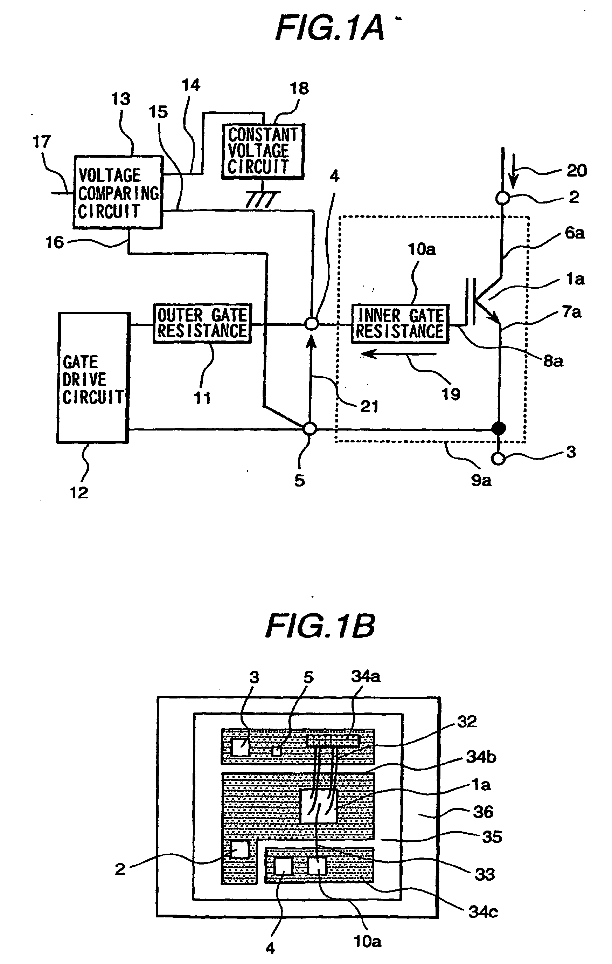

Figure 1A shows a first embodiment. An inner gate resistor (rg) is connected between a gate electrode 8a of an IGBT chip 1a and a gate terminal 4 of an IGBT module 9a, and an outer gate resistor (RG) 11 is connected between the IGBT module 9a and a gate circuit 12. The gate terminal 4 of the IGBT module 9a is connected to an input terminal (B) 15 of a voltage comparing circuit 13, and an auxiliary emitter terminal 5 of the IGBT module 9a is connected to a ground terminal 16 of the gate drive circuit 12 and the voltage comparing circuit 13. A constant voltage circuit 18 is connected to an input terminal (A) 14 of the voltage comparing circuit 13.

Figure 1B is a view showing the inner structure of the IGBT module 9a.

An insulator plate 35 is placed on a heat radiating plate 36, and metal plates 34a, 34b, 34c are placed on the insulator plate 35. A collector electrode portion of the IGBT chip 1a is connected to the metal plate 34b, one end of the inner gate resistor 10a is connected to the metal plate 34c, and the other end of the inner gate resistor 10a is connected to a gate electrode portion of the IGBT chip 1a with a lead wire 33. An electrode 3 for leading out the emitter terminal outside the module, an electrode 2 for leading out the collector terminal outside the module and an electrode 4 for leading out the gate terminal outside the module are connected to each of the metal plates 34a, 34b, 34c.

Referring to Figure 1A, when collector current 20 conducting through the IGBT chip 1a becomes excessively large and temperature of the IGBT chip 1a rises by increase of generated loss of the IGBT chip 1a, temperature of the inner gate resistor (rg) 10a mounting on the same heat radiating plate is also increased. At that time, the value of voltage drop between the both ends of the inner resistor (rg) 10a is changed due to existence of a temperature coefficient of the resistivity which is a physical property possessed by the inner gate resistor (rg) 10a. The change in the voltage drop value of the inner gate resistor (rg) 10a is detected as a voltage (VGE) 21 between the gate and the emitter and input to the input terminal (B) 15 of the voltage comparing circuit 13. A constant voltage value from the constant voltage circuit 18 is input to the other input terminal (A) 14 of the voltage comparing circuit 13, and the result of a voltage comparison performed by the voltage comparing circuit 13 is output from an output terminal 17 of the voltage comparing circuit 13.

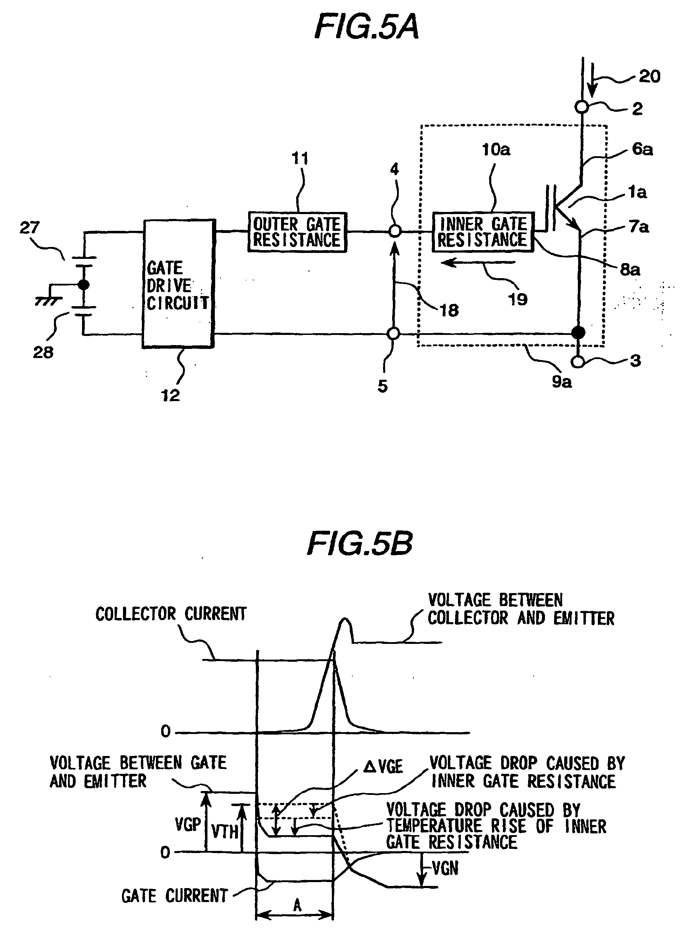

Figure 5A and Figure 5B explain operation of the present embodiment. The timing detecting the change in the voltage drop value generated in the inner gate resistor 10a of the module is the time, referring to Figure 5B, when the voltage (VGE) 21 between the gate and the emitter of the IGBT module 9a is in a Miller effect occurring period A caused by an action of a feedback capacity existing between the collector electrode and the gate electrode of the IGBT chip 1a at turning-off of the IGBT chip 1a. The gate voltage appearing between the gate and the emitter of the IGBT chip 1a in the Miller effect occurring period A described above is a constant value, and the gate current value is a constant value.

The voltage generated between the gate terminal 4 and the auxiliary emitter terminal 5 having the IGBT module 9a shown in Figure 5A is the sum of the constant value of the gate voltage value in the Miller effect occurring period A described above and the voltage value between the both ends of the inner gate resistor 10a of the module.

Operation accompanied the change in the temperature of the IGBT chip in this embodiment will be described below.

The temperature coefficients of the resistivity possessed by the resistors such as the gate resistor mounted inside the module are positive values.

Referring to Figure 1A, when the temperature of the IGBT module 9a is increased, the resistance of the inner gate resistor (rg) 10a is increased depending on the temperature and accordingly the voltage produced in the inner gate resistor (rg) 10a is increased. Therefore, the constant voltage value generated between the gate terminal 4 and the auxiliary emitter terminal 5 in the period of Figure 5B is decreased, and the output terminal 17 of the present temperature sensing circuit performs reversed operation when the voltage value is decreased with respect to the constant voltage value applied to the input terminal (A) 14 of the voltage comparing circuit 13. Depending on the reversed signal of output terminal 17, the other control circuit is operated, for example, the IGBT is turned off.

Referring to Figure 5B, the amount of change ($\Delta$VGE) in the gate voltage produced between the gate terminal 4 and the auxiliary emitter terminal 5 due to the temperature change of the inner gate resistor (rg) 10a in the period A depends on the ratio of the resistance value rg of the inner gate resistor (rg) 10a to the resistance value RG of the outer gate resistor (RG) 11. Letting the temperature coefficient of the inner gate resistor (rg) be $\alpha$, the voltage output from the gate drive circuit 12 in the period A be VGN, and the gate threshold voltage possessed by the IGBT chip 1a depending on a collector current 20 conducting in the IGBT module 9a be VTH, the amount of change $\Delta$VGE in the gate voltage can be expressed by Equation 1.

$$\Delta\text{VGE} = (\alpha \times \text{rg} / (\alpha \times \text{rg} + \text{RG})) \times (\text{VGN} + \text{VTH}) \qquad \textbf{(Equation 1)}$$

According to this equation 1, the temperature change of the inner gate resistor of the module in the period A shown in Figure 5B can be grasped as the amount of change $\Delta$VGE in the gate voltage produced between the gate terminal 4 and the auxiliary emitter terminal 5.

Therefore, the temperature of the IGBT module 9a can be detected by connecting a calculator for calculating temperature based on the equation 1 by inputting the gate voltage instead of the voltage comparing circuit.

Temperature sensing in the present embodiment will be described below in detail.

Referring to Figure 1A, when collector current 20 conducting through the IGBT chip 1a becomes excessively large and temperature of the IGBT chip 1a is increased from 25°C to 125°C corresponding to increase of generated loss of the IGBT chip 1a, the resistance of the inner gate resistor (rg) 10a is increased to approximately twice the value, as shown in Figure 7, and the gate voltage produced between the gate terminal 4 and the auxiliary emitter terminal 5 changes. An example in Figure 5B will be calculated using the equation 1 for the amount of change $\Delta$VGE in the gate voltage. Assuming that VGP = 15 V, VGN = 10 V, VTH = 8 V, RG = 10 $\Omega$, rg = 2$\Omega$ (at 25°C) and rg = 4 $\Omega$ (at 125°C), the results become that $\Delta$VGE = 3 V at 25°C and $\Delta$ VGE = 5.1 V at 125°C, and the difference 2.1 V is the amount of change in the gate voltage caused by the temperature rise. That is, in Figure 5B, the constant voltage values of the gate voltage in the period A are 5 V at 25°C and 2.9 V at 125°C. These voltage values are compared with the constant voltage value applied to the input terminal (A) 14 of the voltage comparing circuit 13 of Figure 1A, and the output of the present temperature sensing device performed reversed operation when the voltage is decreased. For example, when the voltage of the input terminal (A) 14 of the voltage comparing circuit 13 is assumed to be 3 V, the voltage of the input terminal (B) 15 of the voltage comparing circuit 13 is changed from 5 V to 2.9 V to the temperature rise in the IGBT module 9a from 25°C to 125°C, and therefore, temperature sensing operation is performed because the voltage of the input terminal (B) 15 becomes lower than the applied voltage of the input terminal (A) 14.

(Second embodiment)

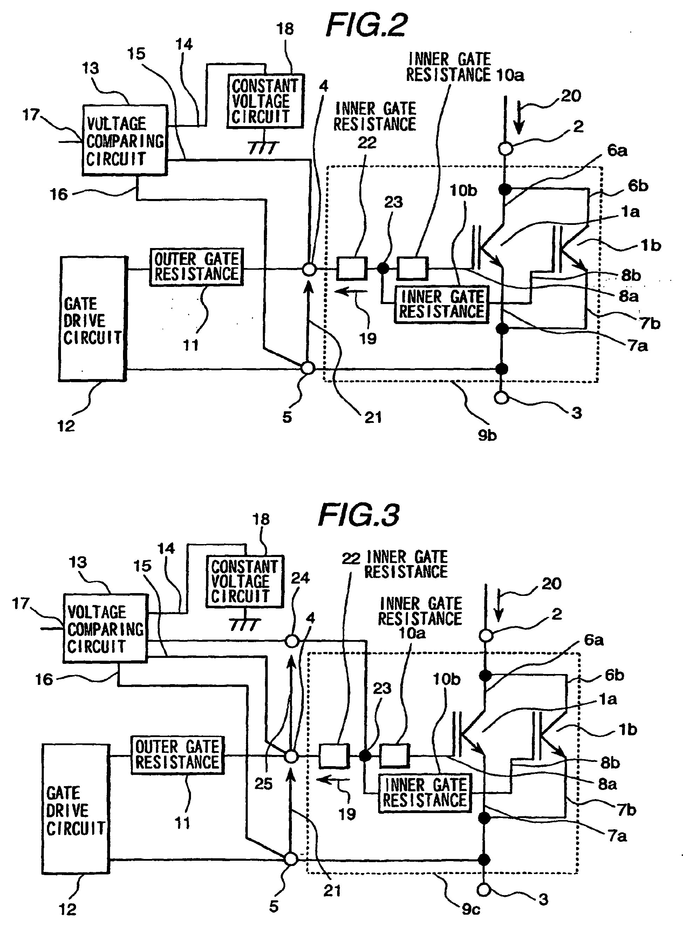

Figure 2 shows a second embodiment. This embodiment is a case where a plurality of IGBTs are connected in parallel. An inner gate resistor (rg) 10a and an inner gate resistor (rt) 22 are connected in series between a gate electrode 8a of an IGBT 1a and a gate terminal 4 of an IGBT module 9b, and an outer gate resistor (RG) 11 is connected between the gate terminal 4 of an IGBT module 9b and a gate drive circuit 12. The gate terminal 4 of the IGBT module 9bis connected to an input terminal (B) 15 of a voltage comparing circuit 13, and an auxiliary terminal 5 of the IGBT module 9b is connected to a ground terminal 16 of the gate drive circuit 12 and the voltage comparing circuit 12. A constant voltage circuit 18 is connected to an input terminal (A) 14 of the voltage comparing circuit 13. Further, a collector electrode 6b of the IGBT 1b is connected to a collector electrode 6a of the IGBT 1a, an emitter electrode 7b of the IGBT 1b is connected to an emitter electrode 7a of the IGBT 1a, and an inner gate resistor (rg) 10b is connected between the gate electrode 22 of the IGBT 1b and point B 23 (that is, a junction point of the inner gate resistor 22 and the inner gate resistor 10a) of one end of the inner gate resistor (rt) 22.
Referring to Figure 2, when the inner gate resistor (rg) 10a of the IGBT 1a and the inner gate resistor (rg) 10b of the IGBT 1b are connected in parallel, an amount of change in the sensing level is decreased because the composite resistance becomes small and accordingly the produced voltage drop is decreased. Therefore, in order to increase the sensing level, the composite resistance is increased to increase the produced voltage drop by connecting the inner gate resistor (rt) 22 to the inner gate resistors (rg) 10a and 10b in series.
As shown in Figure 5B, the timing of temperature sensing is performed in the period A when the voltage (VGE) 21 between the gate and the emitter of the IGBT module 9b becomes a clamp voltage at turning-off of the IGBT 1a and the IGBT 1b. In general, a voltage drop is produced in the inner gate resistor by gate current 19 flowing at turning-off of the IGBT 1a and the IGBT 1b to decrease the clamp voltage. Referring to Figure 2, when the temperature of the IGBT module 9b is increased, the composite resistance of the inner gate resistor is increased depending on the temperature and accordingly the voltage produced in the composite inner gate resistor is increased. Therefore, the clamp voltage in the period of Figure 5B is further decreased, and the present temperature sensing circuit is operated when the voltage value is decreased with respect to the constant voltage value applied to the input terminal (A) 14 of the voltage comparing circuit 13.
Referring to Figure 5B, the amount of change (ΔVGE) in the clamp voltage due to the temperature change of the inner gate resistor in the period A is determined by the ratio of the composite resistance of the inner gate resistors (rg) 10a, 10b and the inner gate resistor (rt) 22 to the resistance of the outer gate resistor (RG) 11. Letting the temperature coefficient of the composite inner gate resistor be α, the composite inner gate resistance be r, the negative voltage applied to the gate terminal 4 be VGN, and the clamp voltage depending on a collector current 20 conducting in the IGBT module 9b be VTH, the amount of change (ΔVGE) in the clamp voltage due to the temperature change of the inner gate resistor in the period A can be expressed by Equation 2.

$$\Delta \text{VGE} = (\alpha \times r / (\alpha \times r + \text{RG})) \times (\text{VGN} + \text{VTH}) \quad \text{(Equation 2)}$$

The temperature change can be detected based on ΔVGE similarly to the first embodiment.

(Third embodiment)

Figure 3 shows a third embodiment. This embodiment is a case where a plurality of IGBTs are also connected in parallel. An inner gate resistor (rg) 10a and an inner gate resistor (rt) 22 are connected in series between a gate electrode 8a of an IGBT 1a and a gate terminal 4 of an IGBT module 9b, and an outer gate resistor (RG) 11 is connected between the gate terminal 4 of an IGBT module 9b and a gate drive circuit 12. The gate terminal 4 of the IGBT module 9bis connected to an input terminal (B) 15 of a voltage comparing circuit 13, and an auxiliary terminal 5 of the IGBT module 9b is connected to a ground terminal 16 of the gate drive circuit 12 and the voltage comparing circuit 12. A constant voltage circuit 18 is connected to an input terminal (A) 14 of the voltage comparing circuit 13. Further, a collector electrode 6b of the IGBT 1b is connected to a collector electrode 6a of the IGBT 1a, an emitter electrode 7b of the IGBT 1b is connected to an emitter electrode 7a of the IGBT 1a, and an inner gate resistor (rg) 10b is connected between the gate electrode 22 of the IGBT 1b and point B 23 (that is, a junction point of the inner gate resistor 22 and the inner gate resistor 10a) of one end of the inner gate resistor (rt) 22. Further, a temperature sensing terminal 24 is provided and connected to the point 23.

Referring to Figure 3, when the inner gate resistor (rg) 10a of the IGBT 1a and the inner gate resistor (rg) 10b of the IGBT 1b are connected in parallel, an amount of change in the sensing level is decreased because the composite resistance becomes small and accordingly the produced voltage drop is decreased. Therefore, by connecting the inner gate resistor (rt) 22 to the inner gate resistors (rg) 10a and 10b in series and further providing the temperature sensing terminal 24 to the point B 23 of the one end of the inner gate resistor (rt) 22, temperature detecting operation is performed by detecting the terminal voltage of the inner gate resistor (rt) 22.

Similarly to Figure 5B, the timing of temperature sensing is performed by the voltage (VTG) between the temperature sensing terminal 24 and the gate terminal 4 in the period A when the voltage (VGE) 21 between the gate and the emitter of the IGBT module 9b becomes a clamp voltage at turning-off of the IGBT 1a and the IGBT 1b. In general, the voltage (VTG) 25 is generated in the inner gate transistor (rt) 22 by the gate current 19 flowing at turning-off of the IGBT 1a and the IGBT 1b to decrease the clamp voltage. Referring to Figure 3, when the temperature of the IGBT module 9b is increased, the resistance of the inner gate resistor (rt) 22 is increased depending on the temperature and the voltage produced in the inner gate resistor 22 is further increased. Then, the present temperature sensing circuit is operated when the voltage value is increased with respect to the constant voltage value applied to the input terminal (A) 14 of the voltage comparing circuit 13.

Referring to Figure 3, letting the temperature coefficient of the inner gate resistor (rt) 22 be $\alpha$, and the gate current be Ig, the amount of change ($\Delta$VTG) in the voltage produced in the inner gate resistor (rt) 22 by the temperature rise in the period A can be expressed by Equation 3.

$$\Delta\text{VTG} = \alpha \times \text{rt} \times \text{Ig} \qquad\qquad \text{(Equation 3)}$$

Similarly to the case of $\Delta$VGE, the temperature change can be detected from the change $\Delta$VTG in the gate voltage.

(Fourth embodiment)

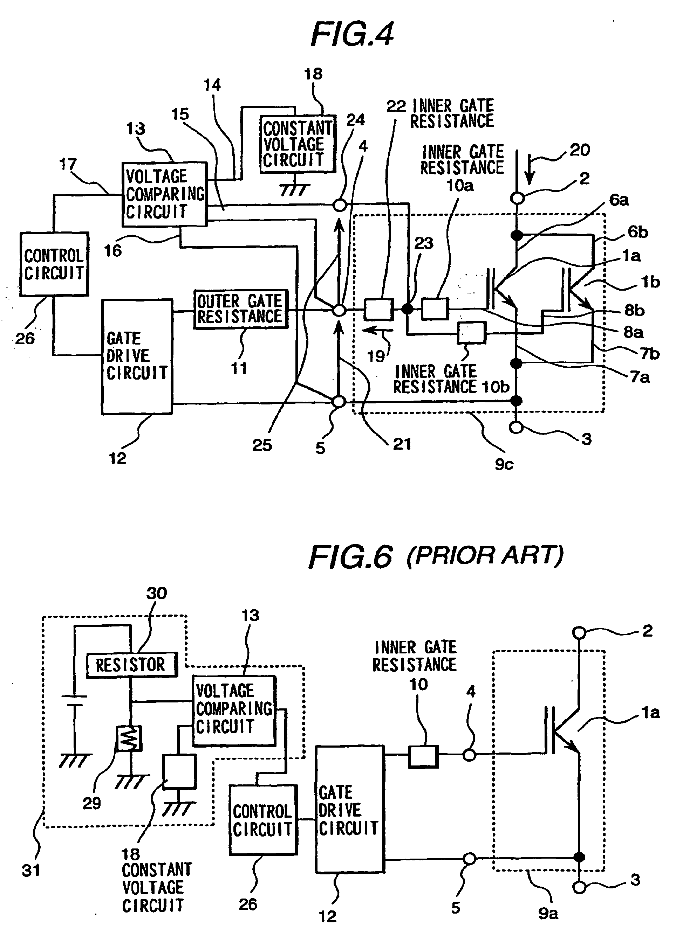

Figure 4 shows a fourth embodiment. In the circuit structure of the third embodiment, the output of the voltage comparing circuit 13 is connected to the control circuit 26, and the output of the control circuit 26 is connected to the gate drive circuit 12.

In the third embodiment, when the terminal voltage of the inner gate resistor 22 is decreased to a value lower than the voltage of the input terminal (A) 14 of the voltage comparing circuit, the voltage comparing circuit 13 regards it as occurrence of abnormality and outputs a signal indicating the abnormality to the control circuit 26. The control circuit 26 outputs an off operation instruction to the gate drive circuit when receiving the signal indicating the abnormality. When the gate drive circuit receives the off operation instruction, the drive circuit performs turning-off drive of the IGBT 1a and the IGBT 1b.

In the above embodiments, an IGBT is used as the switching element. However, In a case of using a voltage drive type switching element such as a power MOSET, the circuit operation is the same as in the above, and the same effect can be attained.

According to the present invention, by connecting a resistor for temperature sensing to a voltage drive type semiconductor device, it is possible to provide a high reliable temperature sensing circuit.

**Claims**

1. A temperature sensing circuit for a voltage drive type semiconductor device, which comprises a first semiconductor element (1a) controlling the current flow between a pair of main electrodes (6a, 7a) by a voltage applied to a first insulated gate electrode (8a), a gate terminal (4) connected to said first insulated gate electrode (8a), and another terminal (5) connected to one of said main electrodes (6a, 7a), comprising

a resistor (10a) having a positive temperature coefficient connected between said gate terminal (4) and said insulated gate electrode (8a), and

means for receiving a voltage including a voltage drop across said resistor (10a) in a circuit portion between said gate terminal (4) and said other terminal (5) and sensing the temperature of said voltage drive type semiconductor device based on said voltage,
**characterised in that** said voltage is a voltage during a Miller effect being generated when said first semiconductor element (1a) turns off.

2. The circuit of claim 1, wherein said resistor (10a) is contained in said voltage drive type semiconductor device.

3. The circuit of claim 1, wherein
said voltage drive type semiconductor device comprises a second semiconductor element (1b) having a second insulated gate electrode (8b) and connected in parallel with said first semiconductor element (1a),and
said resistor comprises a first resistor (10a) and a second resistor (22) connected in series to each other, and a third resistor (10b) connected between the junction point (23) of said first and second resistors (10a, 22) and the second gate electrode (8b).

4. The circuit of claim 3, wherein said voltage is that between said gate terminal (4) and said other terminal (5), or between said gate terminal (4) and said junction point (23)

5. A temperature sensing method for a voltage drive type semiconductor device, which comprises a semiconductor element (1a) controlling the current flow between a pair of main electrodes by a voltage applied to an insulated gate electrode (8a), a gate terminal (4) connected to said insulated gate electrode (8a), and another terminal (5) connected to one of said main electrodes (6a, 7a), the method comprising the steps of:

connecting a resistor (10a) having a positive temperature coefficient between said gate terminal (4) and said insulated gate electrode (8a), and
sensing the temperature of said voltage drive type semiconductor device based on a voltage including a voltage drop across said resistor (10a) in a circuit portion between said gate terminal (4) and said other terminal (5)
**characterised in that** said voltage is a voltage during a Miller effect being generated when said semiconductor element (1a) turns off.

6. A drive device for a voltage drive type semiconductor device, which comprises a first semiconductor element(1a) controlling the current flow between a pair of main electrodes (6a, 7a) by a voltage applied to a first insulated gate electrode (8a), a gate terminal (4) connectedto said first insulated gate electrode (8a), and another terminal (5) connected to one of said main electrodes (6a, 7a), comprising
a drive circuit connected to the gate terminal (4) through a resistor (10a) and connected to said other terminal (5), and the temperature sensing circuit of any one of claims 1 to 4.

7. The device of claim-6, further comprising a control circuit receiving a signal output from said temperature sensing circuit when a temperature rise is detected, and giving an OFF operation instruction to said drive circuit.

**Patentansprüche**

1. Temperaturerfassungsschaltung für ein spannungsgesteuertes Halbleiterbauelement, das ein erstes Halbleiterelement (1a) zum Steuern des Stromflusses zwischen einem Paar Hauptelektroden (6a, 7a) durch eine an eine erste isolierte Gate-Elektrode (8a) angelegte Spannung, einen an die erste Gate-Elektrode (8a) angeschlossenen Gate-Anschluß (4), und einen an eine der Hauptelektroden (6a, 7a) angeschlossenen anderen Anschluß (5), aufweist, mit einem Widerstand (10a) mit positivem Temperaturkoeffizienten, der zwischen dem Gate-Anschluß (4) und der isolierten Gate-Elektrode (8a) angeschlossen ist, und
einer Einrichtung zum Empfangen einer Spannung, die einen Spannungsabfall über den Widerstand (10a) in einem Schaltungsabschnitt zwischen dem Gate-Anschluß (4) und dem anderen Anschluß (5) enthält, und zum Erfassen der Temperatur des spannungsgesteuerten Halbleiterbauelements auf Grundlage der Spannung,
**dadurch gekennzeichnet, daß** die Spannung in einer Spannung während eines Miller-Effekts besteht, der erzeugt wird, wenn das erste Halbleiterelement (1a) abschaltet.

2. Schaltung nach Anspruch 1, wobei der Widerstand (10a) in dem spannungsgesteuerten Halbleiterbauelement enthalten ist.

3. Schaltung nach Anspruch 1, wobei
das spannungsgesteuerte Halbleiterbauelement ein zweites Halbleiterbauelement (1b) aufweist, das eine zweite isolierte Gate-Elektrode (8b) aufweist und parallel zu dem ersten Halbleiterelement (1a) angeschlossen ist, und der Widerstand einen ersten Widerstand (10a) und einen zweiten Widerstand (22) aufweist, die in Serie angeschlossen sind, sowie einen dritten Widerstand (10b), der zwischen dem Verbindungspunkt (23) des ersten und des zweiten Widerstands (10a, 22) und der zweiten Gate-Elektrode (8b) angeschlossen ist.

4. Schaltung nach Anspruch 3, wobei die Spannung die Spannung zwischen dem ersten Gate-Anschluß (4) und dem anderen Anschluß (5), oder zwischen dem Gate-Anschluß (4) und dem Verbindungspunkt (23) ist.

5. Temperaturerfassungsverfahren für ein spannungsgesteuertes Halbleiterbauelement, das ein Halbleiterelement (1a) zum Steuern des Stromflusses zwischen einem Paar Hauptelektroden durch eine an eine isolierte Gate-Elektrode (8a) angelegte Spannung, einen an die isolierte Gate-Elektrode (8a) angeschlossenen Gate-Anschluß (4), und einen an eine der Hauptelektroden (6a, 7a) angeschlossenen anderen Anschluß (5), aufweist, wobei in dem Verfahren:

ein Widerstand (10a) mit einem positiven Temperaturkoeffizienten zwischen dem Gate-Anschluß (4) und der isolierten Gate-Elektrode (8a) angeschlossen wird, und
die Temperatur des spannungsgesteuerten Halbleiterbauelements auf Grundlage einer Spannung erfaßt wird, die einen Spannungsabfall über den Widerstand (10a) in einem Schaltungsabschnitt zwischen dem Gate-Anschluß (4) und dem anderen Anschluß (5) enthält,
**dadurch gekennzeichnet, daß** die Spannung in einer Spannung während eines Miller-Effekts besteht, der erzeugt wird, wenn das Halbleiterelement (1a) abschaltet.

6. Antriebsvorrichtung für ein spannungsgesteuertes Halbleiterbauelement, das ein erstes Halbleiterelement (1a) zum Steuern des Stromflusses zwischen einem Paar Hauptelektroden (6a, 7a) durch eine an eine erste isolierte Gate-Elektrode (8a) angelegte Spannung, einen an die erste isolierte Gate-Elektrode (8a) angeschlossenen Gate-Anschluß (4), und einen an eine der Hauptelektroden (6a, 7a) angeschlossenen anderen Anschluß (5), aufweist, mit einer Antriebsschaltung, die über einen Widerstand (10a) an den Gate-Anschluß (4) angeschlossen ist, und die an den anderen Anschluß (5) angeschlossen ist, und
der Temperaturerfassungsschaltung nach einem der Ansprüche 1 bis 4.

7. Vorrichtung nach Anspruch 6, ferner mit einer Steuerschaltung, die ein Ausgangssignal von der Temperaturerfassungsschaltung empfängt, wenn eine Temperaturerhöhung erfaßt wird, und einen AUS-Betriebsbefehl an die Steuerschaltung gibt.

**Revendications**

1. Circuit de détection de température pour un dispositif à semi-conducteurs de type à commande par la tension, qui comporte un premier élément à semi-conducteurs (1a) commandant la circulation de courant entre une paire d'électrodes principales (6a, 7a) par une tension appliquée à une première électrode de grille isolée (8a), une borne de grille (4) reliée à ladite première électrode de grille isolée (8a), et une autre borne (5) reliée à l'une desdites électrodes principales (6a, 7a), comportant :

une résistance (10a) ayant un coefficient de température positif reliée entre ladite borne de grille (4) et ladite électrode de grille isolée (8a), et
des moyens pour recevoir une tension incluant une chute de tension aux bornes de ladite résistance (10a) dans une partie de circuit entre ladite borne de grille (4) et ladite autre borne (5) et détecter la température dudit dispositif à semi-conducteurs de type à commande par la tension sur la base de ladite tension,
**caractérisé en ce que** ladite tension est une tension durant un effet de Miller généré lorsque ledit premier élément à semi-conducteurs (1a) est désactivé.

2. Circuit selon la revendication 1, dans lequel ladite résistance (10a) est contenue dans ledit dispositif à semi-conducteurs de type à commande par la tension.

3. Circuit selon la revendication 1, dans lequel
ledit dispositif à semi-conducteurs de type à commande par la tension comporte un second élément à semi-conducteurs (1b) ayant une seconde électrode de grille isolée (8b) et relié en parallèle audit premier élément à semi-conducteurs (1a), et

ladite résistance comporte une première résistance (10a) et une deuxième résistance (22) reliées en série l'une à l'autre, et une troisième résistance (10b) reliée entre le point de jonction (23) desdites première et deuxième résistances (10a, 22) et la seconde électrode de grille (8b).

**4.** Circuit selon la revendication 3, dans lequel ladite tension est celle entre la borne de grille (4) et ladite autre borne (5), ou entre ladite borne de grille (4) et ledit point de jonction (23).

**5.** Procédé de détection de température pour un dispositif à semi-conducteurs de type à commande par la tension, qui comporte un élément à semi-conducteurs (1a) commandant la circulation de courant entre une paire d'électrodes principales par une tension appliquée à une électrode de grille isolée (8a), une borne de grille (4) reliée à ladite électrode de grille isolée (8a), et une autre borne (5) reliée à l'une desdites électrodes principales (6a, 7a), le procédé comportant les étapes consistant à :

relier une résistance (10a) ayant un coefficient de température positif entre ladite borne de grille (4) et ladite électrode de grille isolée (8a), et
détecter la température dudit dispositif à semi-conducteurs de type à commande par la tension sur la base d'une tension incluant une chute de tension aux bornes de ladite résistance (10a) dans une partie de circuit entre ladite borne de grille (4) et ladite autre borne (5),
**caractérisé en ce que** ladite tension est une tension durant un effet de Miller généré lorsque ledit élément à semi-conducteurs (1a) est désactivé.

**6.** Dispositif de commande pour un dispositif à semi-conducteurs de type à commande par la tension, qui comporte un premier élément à semi-conducteurs (1a) commandant la circulation de courant entre une paire d'électrodes principales (6a, 7a) par une tension appliquée à une première électrode de grille isolée (8a), une borne de grille (4) reliée à ladite première électrode de grille isolée (8a), et une autre borne (5) reliée à l'une desdites électrodes principales (6a, 7a), comportant :

un circuit de commande relié à la borne de grille (4) via une résistance (10a) et relié à ladite autre borne (5), et
le circuit de détection de température selon l'une quelconque des revendications 1 à 4.

**7.** Dispositif selon la revendication 6, comportant de plus un circuit de commande recevant un signal délivré en sortie par ledit circuit de détection de température lorsqu'une hausse de température est détectée, et envoyant une instruction d'opération de DESACTIVATION audit circuit de commande.

## FIG.1A

## FIG.1B

## FIG.2

## FIG.3

## FIG.4

## FIG.6 (PRIOR ART)

## FIG.5A

## FIG.5B

# FIG.7